# EUROPEAN PATENT SPECIFICATION

(11) **EP 2 784 492 B1**
(45) Date of publication and mention of the grant of the patent: **19.09.2018**
(21) Application number: 13161482.8
(22) Date of filing: 27.03.2013
(51) Int. Cl.: G01N 27/02, G01R 27/22

(54) **Conductivity sensor arrangement, in particular for measuring the conductivity of fluids**
Leitfähigkeitssensoranordnung, insbesondere zum Messen der Leitfähigkeit von Flüssigkeiten
Agencement de capteur de conductivité, en particulier pour mesurer la conductivité de liquides

(43) Date of publication of application: 01.10.2014
(73) Proprietor: Baumer A/S, 8210 Arhus (DK)
(72) Inventor: Jensen, Kurt Möller, 8700 Horsens (DK); Hansen, Kenneth, 8382 Hinnerup (DK); Korovin, Dr. Konstantin, 194021 St. Petersburg (DK)
(74) Representative: Strauss, Steffen

(56) References cited:
- DE-A1- 2 325 055
- US-A1- 2007 008 060
- US-A1- 2010 045 309
- US-B1- 6 600 311

## Description

The invention relates to a conductivity sensor arrangement, in particular for measuring the conductivity of fluids. The invention also relates to a method for measuring the conductivity, especially of fluids.

Different materials, e.g. fluids, have different conductivity. Thus, a material may be classified by measuring its conductivity. In a fluid, the conductivity depends, for example, on the amount and type of dissolved ions in the fluid.

One example of where a fluid is defined depending on its conductivity is the food industry. Fluid conduits, in operation, conduct liquid foodstuffs and need to be cleaned regularly in food processing equipment. It is important to note whether the fluid within the conduit is cleansing fluid or foodstuff, such as milk, before processing resumes after a cleansing cycle.

Another application, also in the food industry, is to identify infections of the udder in animals. If an udder is infected, the conductivity of the milk may change. If only the teat is affected, the change in conductivity will be time-depending, as only the first few drops of milk which rested near the infected area have an altered conductivity.

The hygienic and maintenance requirements for devices used in the food processing technology, conductivity sensors being among them, are very demanding. The conductivity sensors have to be exchanged easily. The fluids to be monitored are biologically active and may degrade many materials, so that the fluid conduits are mostly made of stainless steel. Milking equipment is stored outside even in the winter, requiring it to withstand freezing temperatures. Cleaning temperatures, however, may be well above 100°C to reliably kill germs within the fluid processing chain.

It is known to measure the conductivity of fluids by having electrodes protrude into the fluid. Disadvantages of such an arrangement are that the electrodes are prone to degradation and may lead to deposits of ingredients of the fluids at the electrodes. Further, sealing the electrodes against the fluid conduits takes some effort.

It is also known to wind a coil around the fluid conduit to measure its conductivity in such a case, exchanging the coil means dismounting a section of the fluid conduit.

Further, it is known to use a coil system with a field coil, which is driven with a certain frequency in order to induce eddy currents within the fluid. The eddy currents in turn induce a secondary magnetic field which interferes with the magnetic field of the field coil. A sample coil measures both the secondary magnetic field generated by the eddy currents and the primary magnetic field generated by the field coil. The problem with this configuration is that the strength of the secondary magnetic field is very small. A method and apparatus for measurement fluid properties, including pH value are known from U.S. Pat. Application US 2010 / 004 53 09 A1. In one embodiment, the pH sensor includes a sensing coil and a reference coil in communication with a signal generator, a signal receiver and a data processor. The sensing coil is used to sense the sample fluid. The reference coil is used as reference to eliminate environmental electromagnetic interference and is not exposed to the sample fluid. The electrical response of the reference coil is used by the data processor to calibrate the background electrical environmental of the sensing coil, which is used to eliminate (factor out) environmental electromagnetic interference from the response of the sensing coil. The calibrated response of the sensing coil is analyzed by the data processor to derive a pH value of the intervening sample fluid.

In view of the problems associated with the known conductivity sensor arrangements, it is an object of the invention to improve the signal quality and to reduce the sensitivity towards changes in environmental parameters of the conductivity sensor arrangement while retaining a good maintainability.

This problem is solved according to the invention by a sensor arrangement according to claim 1 and a corresponding method according to claim 14. The conductivity sensor arrangement according to the invention improves the accuracy of the conductivity measurements by providing the compensating coil system which is insulated from the sampling coil system and arranged symmetrically with respect to a magnetically insulating layer. In operation, the compensating coil system generates a second magnetic field, which picks up variations in the conductivity sensor arrangement depending on a change of environmental parameters, such as the temperature. These variations in the second magnetic field may be taken to be representative also for the same locations in the first magnetic field, where they constitute a measurement error. The measurements performed by the compensating coil system may thus be used to compensate errors in the measurements performed by the sampling coil system.

The arrangement and method according to the invention may be further improved as is explained in the following. The individual improvements may be arbitrarily combined depending on whether the advantage associated with a particular improvement is needed for a particular application of the conductivity sensor arrangement or the method.

According to the invention, at least one ferrite layer is arranged between the sampling coil system and the compensating coil system. The ferrite reflects the magnetic field of the sampling coil system and thus increases the magnetic flux in the material to be measured. At the same time, the ferrite effectively insulates the compensating coil system from the magnetic field generated in operation by the sampling coil system. Thus, the magnetic field use for compensation will not be influenced by the magnetic field used for measuring conductivity.

Still according to the invention, the sampling coil system and the compensating coil system are arranged symmetrically with respect to the at least one ferrite.

To improve signal quality, it is of advantage if at least one, preferably both, of the sampling coil system and the compensating coil system comprises at least one field coil and at least one receiver coil. In operation, the field coil may generate a time-varying magnetic field that induces eddy currents in the material, of which conductivity is to be measured. The receiver coil picks up both the primary magnetic field of the field coil and the secondary magnetic field of the induced eddy currents.

To reduce occupied space, at least one of the field coil and the receiver coil, preferably both may be planar. In particular, the field coil and/or the receiver coil may be spirally wound. It is suggested that the number of windings may be very low, e.g. less than four windings for the field coil and/or the receiver coil. For many applications, two windings may suffice.

To further reduce the space occupied by the sampling coil system and/or the compensating coil system, the coils may be nested within each other. For example, if the sampling coil system and/or the compensating coil system comprise in general a first and a second coil, the first coil may be arranged within the second coil. In order to increase the strength of the magnetic field acting upon the material to be measured, and thus to increase the strength of the magnetic field generated by the eddy currents, it is of advantage if the field coil is the outer, second coil and the receiver coil is the first, inner coil.

In order to improve the accuracy of the compensation measurements performed by the compensating coil system, the field coils of the sampling coil system and of the compensating coil system may be connected in series. This ensures that both field coils are energized with the same field current.

For directly compensating measurement errors, the receiver coils of the sampling coil system and of the compensating coil system may be differentially or, synonymously, destructively connected to each other in series.

The body containing or forming the ferrite layer may, in another embodiment, be cylindrical.

The body containing or forming the ferrite layer may have flat surfaces on at least two of its opposite sides, said surfaces are covered by the sampling coil system and the compensating coil system respectively. The flat surfaces that are covered by the sampling coil system and the compensating coil system should be parallel so that the interactions between the body and the compensating coil system on one hand and the body and the sampling coil system on the other hand are symmetrical. In this configuration, the symmetry ensures that the same environment-dependent offset effects apply to both the sampling coil system and the compensating coil system.

Another improvement in reducing the measurement errors may be achieved if the areas on the body that are covered by the sampling coil system and the compensating coil system, respectively, are equal. Again, this symmetry allows a better match of the errors detected by the compensating coil system and the errors measured by the sampling coil system.

At least one of the sampling coil system and the compensating coil system may be fixed onto a surface of the body containing or forming the ferrite layer. One may expect the best results with respect to measurement accuracy if there is no gap between the ferrite layers and the respective coil. In order to facilitate positioning of the coil system, positioning elements may be provided by the body. The positioning elements may comprise at least one depression and/or protrusion on the surface on which the sampling coil system or the compensating coil system is mounted.

The sampling coil system and/or the compensating coil system may, as explained above, comprise at least one coil made of a conductive material which is directly contacting the body containing or forming the ferrite layer, in particularly, directly the ferrite layer. This improves the strength of the magnetic field generated by a field coil and/or the signal strength generated by the receiver coil.

In another embodiment, the conductivity sensor arrangement may further comprise a ferrite back, wherein the compensating coil system is arranged between the ferrite layer and the ferrite back. The ferrite back may be of the same structure as the ferrite layer.

The ferrite layer and the ferrite back may form between each other a receptacle, in which the compensating coil system is received. In particular, the receptacle may be a depression in at least one of the ferrite layer and the ferrite back.

The ferrite back increases the magnetic insulation of the compensating coil system.

A further improvement in the insulation of the compensating coil system may be reached if the compensating coil system is surrounded on at least three sides by ferrite material.

The ferrite layer and the ferrite back may be coupled to each other to form a housing in which at least the compensating coil system is received. In this configuration, the conductivity sensor arrangement is integrated into the unit.

The ferrite layer and the ferrite back are spaced apart from each other by an air gap. The compensating coil system may be distanced from the ferrite back.

In order to reach high temperature stability, at least one of the ferrite layer and the ferrite back contains or consists preferred of a hard ferrite. Hard ferrites are characterized by having magnetic parameters which exhibit very low variation up to approximately 180°C. Further, the thermal expansion coefficient is very low. Thus, temperature drift may be expected to be very low in the conductivity sensor arrangement if hard ferrites are used. A ferrite coated with NiZn shows very high temperature stability with respect to its geometrical and magnetic properties.

For applications where the conductivity sensor arrangement is exposed to temperatures up to 450°C, a NiZn-Ferrite may be used.

Furthermore, in the air gap between the ferrite layer and the ferrite back, at least one compensation element may be arranged. Such a compensation element may, for example, have a specific thermal expansion coefficient to disturb the magnetic field of the compensating coil system in a predetermined manner with varying temperature. Moreover, the compensation element may have magnetic properties which have a predetermined dependency on temperature and/or on the magnetic field. This allows further errors to be compensated.

The sampling coil system may, according to another embodiment, comprise two sub-systems arranged side by side. Each sub-system may comprise at least one receiver coil. In order to allow an efficient compensation by the compensating coil system, it is preferred that the two sub-systems are identical. In particular, the sub-systems may each comprise a receiver coil and/or a field coil, preferably both.

Both the sampling coil system and the compensating coil system may be arranged on a common, flexible PCB to allow an easy mounting of the sensor arrangement.

Further, the conductivity sensor arrangement, according to the invention, may comprise a face plate made of dielectric material. The face plate may be configured to withstand biological and/or chemical and/or physical degradation by the material of which the conductivity is to be measured. The sampling coil system may, in such a configuration, be arranged between the ferrite layer and the face plate. In particular, a front face of the face plate may be configured to be in contact with the material of which the conductivity is to be measured. The front face may, in particular, face away from the sampling coil system.

If the sampling coil system comprises two sub-systems as described above, the face plate may comprise at least two regions, which each respectively overlap an associated sub-system, the distance between the front face in a first of the least two regions and associated sub-system being smaller than the distance between the front face in a second of the least two regions and the associated sub-system. Moreover, the thickness of the face plate may be different in the various regions of the face plate associated with the sub-system. Because of the differing distances of the coils of the sub-systems from the material of which conductivity is to be measured, the characteristics of the two sub-systems will be different. A comparison of the measurements made by the individual sub-systems will thus lead to improved accuracy.

The conductivity sensor arrangement may further comprise a thermal insulation member that at least partially surrounds the ferrite layer and, if present, the ferrite back, and the compensating coil system. The thermal insulation member may form a housing for the sensor arrangement so that it can be integrally handled as a unit. The thermal insulation member reduces exposure of the compensating coil system and the sampling coil system as well as of the ferrite layer and the ferrite back to temperature variations.

The at least one ferrite layer between the compensating coil system and the sampling coil system and/or the ferrite back may be part of a (solid) body, which may contain other layers, in particular other ferrite layers. The body may, in another embodiment, also consist of a single ferrite layer.

The compensating coil system and the sampling coil system may be in operation excited by a frequency ranging between 1 MHz and 100 MHz, preferably between 10 MHz and 50 MHz.

For signal processing, a Gilbert cell may be used. The input terminals of the Gilbert cell may be connected to the receiver coils of the compensating coil system and the sampling coil system. The receiver coils may be used to provide differential input to the Gilbert cell.

The Gilbert cell may in particular be used to demodulate the signal of the receiver coils, which are destructively coupled.

In the following, various embodiments of the conductivity sensor arrangement according to the invention are described by way of example and with reference to the drawings. In the embodiment, various combinations of the improvements described above are shown. These improvements and features may be differently combined if certain advantages need to be realised in a particular application.
- Figure 1: shows a schematic perspective rendition of a first embodiment of a conductivity sensor arrangement according to the invention.
- Figure 2: shows a schematic side view on parts of a second embodiment of the conductivity sensor arrangement according to the invention;
- Figure 3: shows a schematic side view on parts of a third embodiment of a conductivity sensor arrangement according to the invention;
- Figure 4: shows a schematic side view on parts of a fourth embodiment of a conductivity sensor arrangement according to the invention;
- Figure 5: shows a schematic representation of parts of a circuitry for the signal processing of a conductivity sensor arrangement according to the invention.

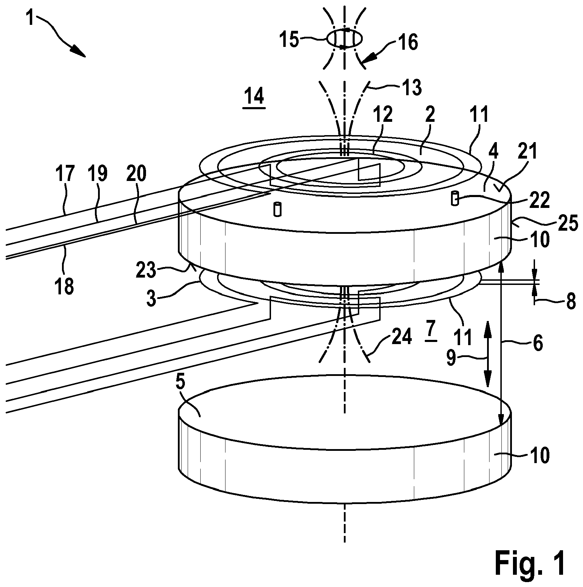

First, the basic configuration of a conductivity sensor arrangement 1 is exemplarily described with reference to the embodiment of Figure 1. The conductivity sensor arrangement 1 is particularly suited to measure the conductivity of fluids but may of course also be used to measure conductivity in any other kind of material.

The conductivity sensor arrangement 1 comprises a sampling coil system 2 and a compensating coil system 3. Between the sampling coil system 2 and the compensating coil system 3, at least one ferrite layer 4 is arranged.

The compensating coil system 3 may be arranged between the ferrite layer 4 and a ferrite back 5. The ferrite back 5 is spaced apart from the ferrite layer 4 by a distance 6 so that an air gap 7 is formed. The distance 6 may in particular be larger than a thickness 8 of the compensating coil system 3 measured in a distance direction 9 of the distance 6.

The ferrite layer 4 and the ferrite back 5 may be cylindrical bodies 10. The bodies 10 may have a circular base to conform to the radial symmetry of any magnetic field generated by the sampling coil system 2 and/or the compensating coil system 3.

The ferrite layer 4 and the ferrite back 5 may be of a homogeneous composition or may be formed by connected layers either of the same or of different material. The ferrite layer 4 and/or the ferrite back 5, or each of the bodies 10, respectively, may contain or consist of a hard ferrite which exhibits very low thermal variation in its magnetic parameters up to and beyond 100°C, in particular to approximately 120°C to 150°C. Moreover, hard ferrites have a very low thermal expansion coefficient. Preferably, the ferrite used in the ferrite layer and/or the ferrite back contains NiZn.

The sampling coil system 2 may comprise two coils 11, 12 which, in particular, may be planar spiral coils with less than four, preferably just two, windings. The coils 11, 12 are nested within each other preferably in a common plane.

As shown in Figure 1, there is an outer coil 11, which surrounds an inner coil 12. The outer coil 11 may be used as a field coil which is excited by an alternating current to generate a time-varying primary magnetic field 13, which is indicated schematically in Figure 1. The frequency of the current ranges between 1 MHz and 100 MHz, preferably between 10 MHz and 50 MHz.

The magnetic field 13 reaches into the fluid 14, of which the conductivity is to be measured. Within the fluid 14, the time-varying magnetic field 13 generates eddy currents 15, which in turn generate a secondary magnetic field 16.

The inner coil 12 may be used as a receiver coil, where both the magnetic field 13 and the secondary magnetic field 16 are superimposed and induce a current.

As the strength of the eddy currents 15 and thus the strength of the secondary magnetic field 16 depend on the conductivity of the fluid 14, the degradation of the magnetic field 13 by the secondary magnetic field 16 may in turn be used as a measure for the conductivity of the fluid 14. This degradation is picked up by the receiver coil 12.

Thus, the sampling coil system 2 constitutes a transformer with the field coil 11 as primary coil, the fluid 14 - of any other material of which the conductivity is to be measured - as magnetic core, and the receive coil 12 as secondary coil.

The ferrite layer 4 reflects the magnetic field 13 into the fluid and, at the same time, insulates the compensating coil system 3 from the primary magnetic field 13, and of course also from the secondary field 16, generated by the field coil 11.

Lines 17 and 18 are used to drive the field coil 11. Lines 19 and 20 are used to pick up the signals from receiver coil 12. The wave resistances of lines 17 to 20 are matched to the wave resistances of coils 11 and 12 so that there is no wave reflection.

The sampling coil system 2 may be directly attached to a surface 21 of the ferrite layer 4 or the body 10, respectively. The surface 21 is preferably flat. The surface 21 may be provided with one or more positioning elements that allow an exact positioning of the sampling coil system 2 on the ferrite layer 4. The positioning elements 22 may be protrusions or depressions on the surface 21.

The sampling coil system 2 is preferably integrated into a PCB 26 (not shown) so that the coils 11 and 12 form a unit. The lines 17 to 20 may be part of the PCB.

The compensating coil system 3 is preferably identical to the sampling coil system 2. Likewise, its fixation and/or positioning to the ferrite layer 4 or the body 10 may correspond to the fixation and/or positioning of the sampling coil system 2. Thus, with respect to the design of the compensating coil system 3, reference may be made to the above description of the sampling coil 2.

However, the conductivity sensor arrangement 1 works also if the geometry of the sampling coil system 2 and the geometry of the compensating coil system 3 are different.

In order to reduce calibration and signal processing efforts, it is preferred that the area covered by the sampling coil system 2 on the surface 21 corresponds to the area covered by the compensating coil system 3 on a surface 23 of the ferrite layer 4 and/or the body 10. The surface 23 forms an opposite face to the surface 21 of the ferrite layer 4 and/or the body 10, respectively. The surfaces 21 and 23 should be parallel. The sampling coil system 2 and the compensating coil system 3 are arranged symmetrically on their respective surfaces 21, 23.

As stated above, the compensating coil system 3 is insulated by the ferrite layer 4 from the magnetic fields 13, 16 acting on the side of the sampling coil system 2.

In the compensating coil system 3, the field coil 11 generates a magnetic field 24, which is picked up by the receiver coil 12 as the magnetic field 24.

Due to the symmetric arrangement of the compensating coil system 3 and the sampling coil system 2, both receiver coils 12 pick up the same influences from the ferrite layer 4 and/or the body 10, respectively. Thus, if the permeability, and/or its geometry, of the ferrite layer 4 changes with a change in temperature, this contribution will affect the same change in the signals of both receiver coils. Thus, a subtraction of the signal from the receiver coil 12 of the compensating coil system 3 from the signal of the receiver coil 12 of the sampling coil system 2 may eliminate such error contributions.

Variations of the embodiments shown in Figure 1 are possible. For example, the outer coil 11 may be used as the receiver coil and the inner coil 12 may be used as the field coil 12.

As long as the surface 21 and/or the surface 23 are not made from electrically conductive material, the electrically conducting material of the coils 11, 12 may be directly positioned onto the surfaces 21, 23. This ensures that that no wave pattern develops between the coils 11, 12 and the ferrite layer 4.

It is preferred that the ferrite layer 4 or the body 10 is not conductive so that no eddy currents and consequently no secondary magnetic field is generated within the ferrite layer 4 and/or body 10. Together with the back ferrite 5 this ensures that the receiver coil 12 of the compensating coil system 3 is not influenced by stray secondary magnetic fields.

As with the sampling coil system 2, the compensating coil system 3 may be integrated into a PCB. In another variant, both the sampling coil system 2 and the compensating coil system 3 may be combined on a single, flexible PCB, which extends around a side face 25 of the ferrite layer 4 and/or body 10 (not shown).

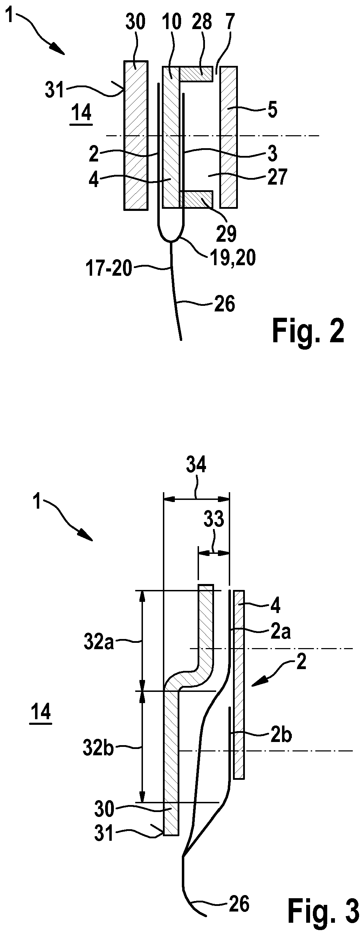

Figure 2 shows a schematic side view of a second embodiment, in which the reference numerals from the first embodiment are used for elements that correspond to each other in function and/or design.

In Figure 2, it can be seen that the sampling coil system 2 and the compensating coil system 3 are combined in a flexible PCB 26. It is further shown that the body 10 and the back ferrite 5 may form a cavity 27, in which the compensating coil system 3 is received. Thus, the compensating coil system 3 may be surrounded on at least three sides by at least one ferrite layer 4, 5. Providing a side wall 28 extending away from the sampling coil system 2 may increase signal quality of the compensating coil system 3. The side wall 28 may be provided with an opening 29 for lines 19, 20.

If a side wall 28 with at least one ferrite layer, in particular the ferrite layer 4, is used, the distance 6 defining the air gap 7 is measured from the end of the side wall 28. Thus, the air gap 7 is defined by the smallest distance between the ferrite layer 4 and the back ferrite 5.

The embodiment of Figure 2 further features a face plate 30 which is positioned between the fluid 14 and the sampling coil system 2. The face plate 30 is made from a dielectric material so that it does not influence the magnetic fields 13, 16.

The face plate 30 forms a mechanical barrier between the sampling coil system 2 and the fluid 14. It is made from a material which is not degraded by a continuous contact with biologically and/or chemically active fluids. Further, surface 31 of the face plate 30, which faces into the fluid, is preferably polished, so that no depositions can form when the conductivity sensor arrangement 1 is operated for an extended time. The face plate 30 may be integrated into the conductivity sensor arrangement but is preferably exchangeable to allow access to the sampling coil system. Furthermore, different conductivity sensor arrangements may be combined with face plates of varying thickness in order to adapt the sensitivity of the sampling coil system 2 to the fluid 14 and the geometry within which the conductivity measurements take place.

Figure 3 shows another embodiment of a conductivity sensor arrangement 1, of which only parts are shown. Again, the reference numerals of the preceding embodiments are used for the parts and elements.

In this embodiment, the sampling coil system 2 is provided with two sampling sub-systems 2a and 2b, which are preferably of identical configuration. Each sub-system 2a, 2b is configured like the sampling coil system 2 in one of the two preceding embodiments, i.e. comprised a field and a receiver coil 11, 12.

The face plate 30 comprises a front face 31 which faces away from the sampling coil system 2. The front face 31 comprises a region 32a, which envelops or faces the sub-system 2a, and a region 32b, which envelops or faces the sub-system 2b. A distance 33 between the first sub-system a and the first face 30 in the region 32a is smaller than the distance 34 between the second sub-system 2b and the front face 30 in the region 32b. In operation, this results in the fluid 14 being at different distances from the respective sub-systems 2a, 2b. The sub-systems 2a, 2b therefore have different characteristic curves. Comparison of their respective signals allows further errors to be compensated.

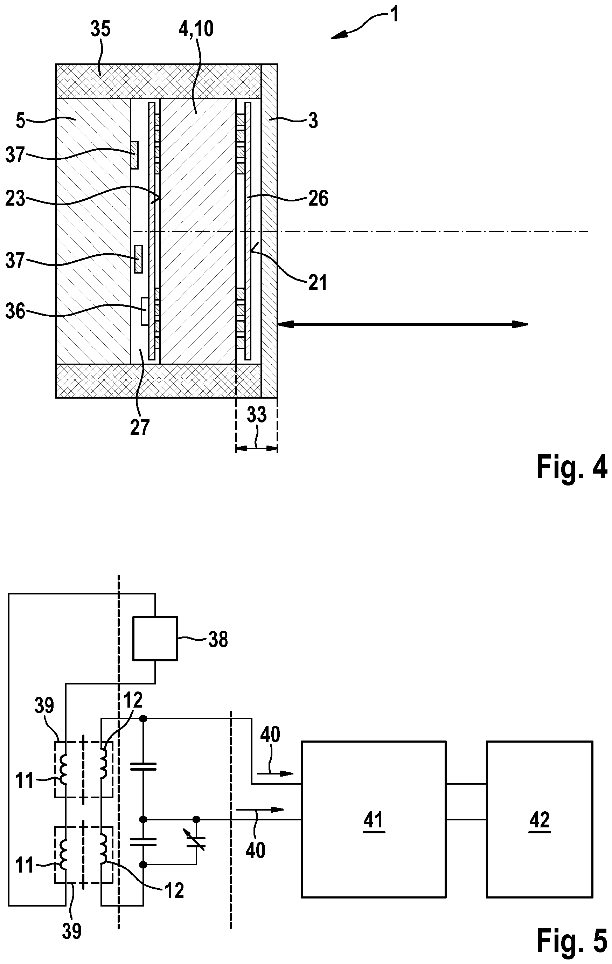

In Figure 4, a schematic side view of another embodiment of a conductive sensor arrangement 1 is shown. Again, the same reference numerals as in the previous embodiments are used for elements that correspond to each other in function and/or design. The conductive sensor arrangement 1 forms a unit that can be plugged into food processing machinery.

As can be seen in Figure 4, the coils 11, 12 of the sampling coil system 2 and the compensating coil system 3 are directly in contact with surfaces 21, 23 of the ferrite layer 4 and the body 10.

The conductivity sensor arrangement 1 of Figure 4 comprises a heat insulation 35 which surrounds, at least on the sides, bur preferably also on the back, the ferrite layer 4, the sampling coil system 2, the compensating coil system 3 and, if present, the back ferrite 5.

The conductivity sensor arrangement 1, in particular the PCB 26, may comprise a thermal sensor 36. A signal of the thermal sensor 36 may be used by signal processing routines for further error compensation.

The thermal sensor 36 may also be a separate element, which is located not on the PCB but on a position which is known to be representative for the overall temperature of the conductivity sensor arrangement.

As Figure 4 further shows, at least one compensation element may be present in the cavity 27 in which the compensating coil system 3 is received. The at least one compensating element 37 may for example be a magnetic material having a certain temperature-varying permeability and/or geometry which allows a compensation and/or linearization of measurement errors if the compensating element 37 is located within the magnetic field 24 generated by the compensating coil system.

In the schematic circuit diagram of Figure 5, it can be seen that the field coils 11 are driven by an excitation source 38. The driven field coils 11 form, together with the associated receiver coils 12, two transformer sections 39. The field coils 11 may be connected in series constructively, whereas the receiver coils 12 may be connected in series destructively. Thus, the signals generated by the two receiver coils 12 tend to cancel each other. As the frequency of the signal generated by the receiver coils 12 is in the range of 10 MHz to 100 MHz and as the signal strength is very weak, the differential signal 40 from the receiver coils 12 is input into a Gilbert cell 41 for further processing. The Gilbert cell is known from mobile phone applications, where it is operated under different conditions than in the present case. Nonetheless, it was discovered that the Gilbert cell is highly effective for processing the signals of the receiver coils. The Gilbert cell 41 demodulates the signal from the receiver coils 12. The signals output from the Gilbert cell 41 may be inputted into an interface 42.

## Claims

1. Conductivity sensor arrangement (1), in particular for measuring the conductivity of fluids (14), comprising
- a sampling coil system (2) for measuring conductivity and
- a compensating coil system (3) for compensating measurement errors of the sampling coil system (2),
wherein the compensating coil system (3) is magnetically insulated from the sampling coil system (2),
wherein at least one body (10) consisting of or comprising at least one ferrite layer (4) is arranged between the sampling coil system (2) and the compensating coil system (3),
wherein the sampling coil system (2) and the compensating coil system (3) are arranged symmetrically with respect to the at least one ferrite layer (4).

2. Conductivity sensor arrangement (1) according to claim 1, wherein at least one of the sampling coil system (2) and the compensating coil system (3) comprises at least one field coil (11) and one receiver coil (12), the receiver coil (12) being arranged within the field coil (11).

3. Conductivity sensor arrangement (1) according to claim 2, wherein the field coil (11) of at least one of the sampling coil system (2) and the compensating coil system (3) are connected in series.

4. Conductivity sensor arrangement (1) according to claims 3, wherein the receiver coils (12) of the sampling coil system (2) and the compensating coil system (3) are differentially connected to each other.

5. Conductivity sensor arrangement (1) according to any one of claims 1 to 4, wherein at least one of the sampling coil system (2) and the compensating coil system (3) comprises at least one coil (11, 12) made of a conductive material, which is in direct contact with the ferrite layer (4).

6. Conductivity sensor arrangement (1) according to any one of claims 1 to 5, wherein the sampling coil system (2) comprises at least two sub-systems (2a, 2b) arranged side by side, each sampling sub-system (2a, 2b), comprising at least a receiver coil (12).

7. Conductivity sensor arrangement (1) according to any one of claims 1 to 6, wherein the sampling coil system (2) and the compensating coil system (3) are covering corresponding surface areas on opposite sides of the body (10).

8. Conductivity sensor arrangement (1) according to any one of claims 1 to 7, which further comprises a ferrite back (5), the compensating coil system (3) being arranged between the ferrite layer (4) and the ferrite back (5).

9. Conductivity sensor arrangement (1) according to claim 6 or 7, wherein the ferrite layer (4) and the ferrite back (5) are spaced apart from each other by an air gap (7), and wherein the compensating coil system (3) is distanced from the ferrite back (5).

10. Conductivity sensor arrangement (1) according to any one of claims 1 to 9, further comprising a face plate (30) made of dielectric material, a sampling coil system (2) being arranged between the ferrite layer (4) and the face plate (30).

11. Conductivity sensor arrangement (1) according to claim 10, wherein the face plate (30) comprises at least two regions (32a, 32b), which respectively overlap an associated sub-system (2a, 2b), a distance (33) between the face plate (30) in a first (32a) of the least two regions (32a, 32b) and the associated sub-system (2a) being smaller than the distance (34) between the face plate (30) in a second (32b) of the least two regions (32a, 32b) and the associated sub-system (2b).

12. Conductivity sensor arrangement (1) according to any one of claims 1 to 11, further comprising a Gilbert cell (41) being connected to the receiver coil (12) of the sampling coil system (2) and the compensating coil system (3).

13. Conductivity sensor arrangement (1) according to any one of claims 1 to 9, wherein at least one of the ferrite layer (4) and the ferrite back (5) contains or consists of a hard ferrite in particular said ferrite containing NiZn.

14. Method for measuring the conductivity in a material, in particular a fluid (14), using the sensor arrangement according to claim 1, the method comprising the steps of: generating and measuring a first magnetic field (13, 16) reaching into the material, and generating and measuring, at the same time a second magnetic field (24), which is magnetically insulated from the first magnetic field (13, 16).

## Patentansprüche

1. Anordnung für einen Leitfähigkeitssensor (1), insbesondere zur Bestimmung der Leitfähigkeit einer Flüssigkeit, bestehend aus
- einem Mess- Spulen-System (2) zur Messwertermittlung der Leitfähigkeit
- einem Kompensations-Spulen-System (3) zur Korrektur von Messwertverfälschungen des Mess-Spulen-Systems (2)
wobei das Kompensations-Spulen-System vom Mess- Spulen-System magnetisch isoliert ist,
wobei wenigstens ein Körper (10), bestehend oder beinhaltend wenigstens einer Lage eines Ferritmaterials (4), zwischen dem Mess- Spulen-System (2) und dem Kompensations-Spulen-System (3) angeordnet ist, wobei das Mess- Spulen-System (2) und das Kompensations-Spulen-System (3) symmetrisch zur wenigstens einen Lage eines Ferritmaterials (4) angeordnet sind.

2. Anordnung für einen Leitfähigkeitssensor (1) nach Anspruch 1, wobei wenigstens eines
des Mess- Spulen-Systems (2) oder Kompensations-Spulen-Systems (3)
eine Erregerspule (11) und eine Empfängerspule (12) beinhaltet,
wobei sich die Empfängerspule (12) innerhalb der Erregerspule (11) befindet.

3. Anordnung für einen Leitfähigkeitssensor (1) nach Anspruch 2, wobei die Erregerspulen (11) von wenigstens einem Mess- Spulen-System (2) und Kompensations-Spulen-System (3) in Serie geschalten sind.

4. Anordnung für einen Leitfähigkeitssensor (1) nach Anspruch 3, wobei die Empfängerspulen (12) von wenigstens einem Mess- Spulen-System (2) und Kompensations-Spulen-System (3) differenziell zueinander verschalten sind.

5. Anordnung für einen Leitfähigkeitssensor (1) nach einem der Ansprüche 1 bis 4, wobei wenigstens eines des Mess- Spulen-Systems (2) und Kompensations-Spulen-Systems (3) eine Spule (11, 12) beinhaltet, gebildet aus einem leitfähigen Material, welches in direktem Kontakt mit der Lage eines Ferritmaterials (4) steht.

6. Anordnung für einen Leitfähigkeitssensor (1) nach einem der Ansprüche 1 bis 5, wobei ein Mess- Spulen-System (2) aus wenigstens zwei Teilsystemen besteht, die nebeneinander angeordnet sind und je eine Empfangsspule (12) enthalten.

7. Anordnung für einen Leitfähigkeitssensor (1) nach einem der Ansprüche 1 bis 6, wobei ein Mess- Spulen-System (2) und ein Kompensations-Spulen-System (3) auf den jeweils gegenüberliegenden Oberflächen des Körpers (10) angeordnet sind.

8. Anordnung für einen Leitfähigkeitssensor (1) nach einem der Ansprüche 1 bis 7, zusätzlich beinhaltend eine rückwärtige Lage eines Ferritmaterials (5), wobei das Kompensations-Spulen-System (3) zwischen dieser und der einen Lage eines Ferritmaterials (4) angeordnet ist.

9. Anordnung für einen Leitfähigkeitssensor (1) nach Anspruch 6 oder 7, bei der die eine Lage eines Ferritmaterials (4) und die rückwärtige Lage eines Ferritmaterials (5) durch einen Luftspalt getrennt angeordnet sind und das Kompensations-Spulen-System (3) von der rückwärtigen Lage eines Ferritmaterials (5) beabstandet ist.

10. Anordnung für einen Leitfähigkeitssensor (1) nach einem der Ansprüche 1 bis 9, beinhaltend eine Trennwand (30) aus einem dielektrischen Material, wobei ein Mess- Spulen-System (2) zwischen dieser und der Lage eines Ferritmaterials (4) angeordnet ist.

11. Anordnung für einen Leitfähigkeitssensor (1) nach Anspruch 10, wobei die Trennwand (30) mindestens zwei Bereiche aufweist (32a, 32b), welche entsprechend je ein Teilsystem (2a, 2b) überdecken, sowie einen Abstand (33) zwischen der Trennwand (30) in einem ersten Bereich (32a) von mindestens zwei Bereichen (32a, 32b) und dem zugehörigen Teilsystem (2a) der kleiner ist als der Abstand (34) zwischen der Trennwand (30) in einem zweiten Bereich (32b) von mindestens zwei Bereichen (32a, 32b) und dem zugehörigen Teilsystem (2b).

12. Anordnung für einen Leitfähigkeitssensor (1) nach einem der Ansprüche 1 bis 11, weiter beinhaltend eine Gilbert-Zelle (41), welche an die Empfängerspulen (12) des Mess- Spulen-System (2) und des Kompensations-Spulen-System (3) angeschlossen ist.

13. Anordnung für einen Leitfähigkeitssensor (1) nach einem der Ansprüche 1 bis 9, wobei wenigstens eine der Lagen des Ferritmaterials (4) oder rückwärtigen Ferritmaterials (5) aus einem weichferritischen Werkstoff bestehet oder einen solchen beinhaltet, im speziellen NiZn.

14. Verfahren zur Messung der Leitfähigkeit in einem Material, insbesondere in einer Flüssigkeit, mit der Sensoranordnung aus Anspruch 1 durch Erzeugen und Messen eines ersten magnetischen Feldes (13, 16), welches das Material erreicht, und gleichzeitiges Erzeugen und Messen eines zweiten magnetischen Feldes (24), welches magnetisch isoliert vom ersten magnetischen Feld ist (13, 16).

## Revendications

1. Dispositif de capteur de conductivité (1), conçu en particulier pour la mesure de la conductivité de fluides (14), consistant
- en une bobine d'échantillonnage (2) pour la mesure de la conductivité et
- en une bobine de compensation (3) pour la compensation des erreurs de mesure de la bobine d'échantillonnage (2),
dans lequel la bobine de compensation (3) est magnétiquement isolée de la bobine d'échantillonnage (2),
dans lequel au moins un disque (10) consistant au moins en une couche de ferrite ou comprenant au moins une couche de ferrite (4) est placé entre la bobine d'échantillonnage (2) et la bobine de compensation (3),
dans lequel la bobine d'échantillonnage (2) et la bobine de compensation (3) sont placées symétriquement par rapport à la ou aux couches de ferrite (4).

2. Dispositif de capteur de conductivité (1) selon la revendication 1, dans lequel au moins une
des bobines d'échantillonnage (2) et de compensation (3) comprend au moins une bobine inductrice (11) et une bobine réceptrice (12), la bobine réceptrice (12) étant placée dans la bobine inductrice (11).

3. Dispositif de capteur de conductivité (1) selon la revendication 2 dans lequel les bobines inductrices (11) d'au moins une bobine d'échantillonnage (2) et de compensation (3) sont raccordées en série.

4. Dispositif de capteur de conductivité (1) selon la revendication 3, dans lequel les bobines réceptrices (12) de la bobine d'échantillonnage (2) et de compensation (3) sont différentiellement raccordées.

5. Dispositif de capteur de conductivité (1) selon l'une des revendications 1 à 4, dans lequel au moins une des bobines d'échantillonnage (2) et de compensation (3) comprend au moins une bobine (11, 12) en matériau conducteur en contact direct avec la couche de ferrite (4).

6. Dispositif de capteur de conductivité (1) selon l'une des revendications 1 à 5, dans lequel la bobine d'échantillonnage (2) comprend au moins deux sous-systèmes (2a, 2b) placés côte à côte, chaque sous-système d'échantillonnage (2a, 2b) comprenant au moins une bobine réceptrice (12).

7. Dispositif de capteur de conductivité (1) selon l'une des revendications 1 à 6, dans lequel la bobine d'échantillonnage (2) et la bobine de compensation (3) couvrent les surfaces correspondantes des faces opposées du disque (10).

8. Dispositif de capteur de conductivité (1) selon l'une des revendications 1 à 7, qui comprend de plus une face arrière en ferrite (5), la bobine de compensation (3) étant placée entre la couche de ferrite (4) et la face arrière en ferrite (5).

9. Dispositif de capteur de conductivité (1) selon la revendication 6 ou 7 dans lequel la couche de ferrite (4) et la face arrière en ferrite (5) sont séparées par une lame d'air (7) et dans lequel la bobine de compensation (3) est séparée de la face arrière en ferrite (5).

10. Dispositif de capteur de conductivité (1) selon l'une des revendications 1 à 9, comprenant de plus une plaque avant (30) en matériau diélectrique, une bobine d'échantillonnage (2) étant placée entre la couche de ferrite (4) et la plaque avant (30).

11. Dispositif de capteur de conductivité (1) selon la revendication 10 dans lequel la plaque frontale (30) est composée d'au moins deux zones (32a, 32b) qui chevauchent respectivement un sous-système associé (2a, 2b), une distance (33) entre la plaque avant (30) dans une première (32a) d'au moins deux zones (32a, 32b) et le sous-système associé (2a) étant inférieure à la distance (34) entre la plaque avant (30) dans une deuxième zone (32b) d'au moins deux zones (32a, 32b) et le sous-système associé (2b).

12. Dispositif de capteur de conductivité (1) selon l'une des revendications 1 à 11, comprenant de plus une cellule Gilbert (41) connectée à la bobine réceptrice (12) de la bobine d'échantillonnage (2) et de la bobine de compensation (3).

13. Dispositif de capteur de conductivité (1) selon l'une des revendications 1 à 9, dans lequel au moins une couche de ferrite (4) et la face arrière en ferrite (5) contient au moins une ferrite dure, soit de la ferrite contenant du NiZn.

14. Méthode de mesure de la conductivité dans un matériau, en particulier un fluide (14), à l'aide du dispositif de capteur selon la réclamation 1, la méthode comprenant les étapes de génération et mesure d'un premier champ magnétique (13, 16) à l'intérieur du métal, et de génération et mesure simultanées d'un deuxième champ magnétique (24) magnétiquement isolé du premier champ magnétique (13, 16).
